# EUROPÄISCHE PATENTSCHRIFT

(11) **EP 0 815 627 B1**
(45) Veröffentlichungstag und Bekanntmachung des Hinweises auf die Patenterteilung: **14.07.1999**
(21) Anmeldenummer: 96909101.6
(22) Anmeldetag: 20.03.1996
(51) Int. Cl.: H02G 15/04, H02G 3/06

(54) **ABDICHTENDE KABELDURCHFÜHRUNG FÜR GESCHIRMTE KABEL**
SEALING CABLE DUCT FOR SCREENED CABLES
PASSE-CABLE CREANT UNE ETANCHEITE POUR CABLES BLINDES

(30) Priorität: 24.03.1995 DE 19510896
(43) Veröffentlichungstag der Anmeldung: 07.01.1998
(73) Patentinhaber: Jacob GmbH, 71387 Kernen (DE)
(72) Erfinder: GEROLDINGER, Arnold, D-85774 Unterföhring (DE)
(74) Vertreter: Schmitt, Meinrad, Dipl.-Ing.
(86) Internationale Anmeldenummer: EP9601212
(87) Internationale Veröffentlichungsnummer: WO9630985

(56) Entgegenhaltungen:
- DE-A- 1 540 027
- DE-A- 2 757 653
- DE-A- 3 737 345

## Beschreibung

Die Erfindung betrifft eine abdichtende Kabeldurchführung für geschirmte Kabel mit einem in eine Gehäusewandbohrung einzusetzenden rohrförmigen Gewindestutzen, einer auf ein gehäusewandaußenseitiges Gewinde des Gewindestutzens aufzuziehenden Klemm-Mutter, mit einer im Inneren des Gewindestutzens axial verschieblichen Druck-Ringscheibe, die durch eine von der Klemm-Mutter anzupressende Quetschdichtung gegen eine radial einwärtsstehende Ringschulter am Gewindestutzen gedrückt wird und einer zwischen die Kabelschirmung und die Kabellitze(n) einzuschiebenden Schirmhülse, die am stimseitigen Ende der Kabelschirmung mindestens einen radial abstehenden Ansatz aufweist,

Es sind HF-sichere, d. h. EMV-gerechte, durch Verschrauben abzudichtende Kabeldurchführungen für geschirmte Kabel bekannt, bei denen nach Entfernen eines äußeren Kabelmantels ein das Kabel umgebendes Schirmgeflecht freigelegt wird, das mit dem Gehäuse der Kabeldurchführung und/oder mit der Innenwand des Gehäuses bzw. mit einem Chassis oder dergleichen elektrisch zu verbinden ist. Ein erwünschter gutleitender und HF-dichter Kontakt der Abschirmung läßt sich erzielen durch Verwenden einer über der Abschirmung sitzenden Druck-Ringscheibe, die beispielsweise über eine ringförmige Quetschdichtung aus Kautschukmaterial durch Aufziehen einer Klemm-Mutter auf einen die Gehäusewand durchsetzenden Gewindestutzen durch Verschrauben angepreßt wird. Bei dieser Art der HF-dichten Fixierung tritt fast regelmäßig ein Ausfransen des Schirmgeflechts ein. Dies deshalb, weil bei häufig nachfolgenden Montageschritten, beispielsweise bei einer weiteren Steckermontage, das Kabel mit dem freigelegten Schirmgeflecht arbeitsbedingt innerhalb der Kabelverschraubung zumindest einmal hin- und herverschoben werden muß. Dabei kann es leicht geschehen, daß Drahtendstücke des Schirmgeflechts abbrechen und innerhalb des Gerätegehäuses Ursache für elektrische Störungen sein können.

Eine HF-dichte Kabelverschraubung, wobei es um die Fixierung eines Koaxialkabels mit einem Außen- und einem Innenleiter und einem zwischenliegenden Dielektrikum geht, ist beispielsweise aus der DE-A-27 57 653 bekannt. Innerhalb eines Gewindestutzens ist eine Hülse mit einem Ansatz vorgesehen. Bei der Montage wird der Außenleiter auf die Hülse aufgeschoben, während der Innenleiter und das Dielektrikum in die Hülse eingeschoben werden. Die Festlegung und die Abdichtung des Koaxialkabels wird durch das Aufbringen eines Druckringes auf den Außenleiter und durch eine Druckmutter erreicht, welche den Druckring mit Kraft beaufschlagt, während sie in das Innengewinde eines Gehäuses eingeschraubt wird. Das auf die Hülse zu schiebende Ende des Außenleiters ist geschlitzt und aufgeweitet. Auch hier besteht - wie bei den Drahtendstücken eines freigelegten Schirmgeflechts - die Gefahr einer mechanischen Beschädigung des Außenleiters und durch abgebrochene Teile auftretende elektrische Störungen.

Der Erfindung liegt damit die Aufgabe zugrunde, eine abdichtende Kabeldurchführung für geschirmte Kabel mit Kabelverschraubung so auszubilden, daß einerseits die Montage wesentlich vereinfacht und Montagezeit eingespart wird und andererseits die Beweglichkeit des Kabels in beiden Achsrichtungen, z. B. während einer - nachfolgenden Kabelkonfektionierung, erhalten bleibt.

Erfindungsgemäß wird diese Aufgabe bei einer abdichtenden Kabeldurchführung für geschirmte Kabel nach der eingangs beschriebenen Gattung gelöst durch eine auf der Außenseite der Kabelschirmung über die Schirmhülse zu schiebende Prägehülse, die beispielsweise mittels einer Krimpzange mit Andruck auf das Schirmgeflecht preßverformt wird und durch mindestens eine auf den mindestens einen radialen Ansatz der Schirmhülse angepaßte, durchgehende Axialausnehmung in der Ringschulter des Gewindestutzens.

Der radial abstehene Ansatz der Schirmhülse kann vorzugsweise paarweise in Form von diametral gegenüberstehenden abgerundeten Lappen ausgebildet sein, wozu auf das weiter unten beschriebene Ausführungsbeispiel verwiesen wird.

Auf der Innenseite der Ringschulter kann beispielsweise um 90° gegen die durchgehende Axialausnehmung versetzt, eine auf den radialen Ansatz der Schirmhülse angepaßte gesenkte Ausnehmung vorhanden sein zur drehgesicherten Verrastung und Kontaktverbesserung für die mittels der Prägehülse auf dem Schirmgeflecht des Kabels fixierte Schirmhülse. Vorteilhafterweise besteht die Prägehülse aus einem weichen Material, beispielsweise aus Kupfer im Vergleich zum Material der Schirmhülse, das etwa aus Messing bestehen kann.

Weiterhin ist es vorteilhaft die abdichtende Quetschdichtung zur Verbesserung des elektrischen Übergangswiderstands innerhalb der Kabelverschraubung aus einem Elastomer mit eingelagertem leitfähigem Material, beispielsweise mit eingelagerten Leitdrähten, herzustellen.

Eine erfindungsmäße verschraubte Kabeldurchführung ermöglicht eine ausreichende Bewegungsfreiheit eines vorkonfektionierten Kabels sowohl nach innen, d.h. innerhalb eines Gehäuses, als auch nach außen, wobei das vorhandene Schirmgeflecht HF-sicher und ohne auszufransen mit dem Gewindestutzen verbunden bleibt. Während des gesamten Verarbeitungsprozesses des Kabels ist durch die erfindungsgemäße Art der mechanischen und elektrischen Anbindung der Kabelabschirmung das gefürchtete Ausfransen des Schirmgeflechts unmöglich. Auch eventuell später auftretende Kurzschlüsse oder sonstige Probleme durch abgebrochene Schirmgeflechtteile sind ausgeschlossen. Das vorkonfektionierte mit Schirmhülse und Prägehülse versehene Kabel kann in einer bestimmten Winkelstellung durch den Gewindestutzen durchgezogen werden, wobei der abstehende Ansatz bzw. die radial gegenüberstehenden Lappenansätze durch die vorgesehene(n) Axialausnehmung bzw. die radial gegenüberstehenden Axialausnehmungen in der Ringschulter des Gewindestutzens hindurchrutschen. Dabei kann eine zuvor abgemantelte Litzenlänge des Kabels auf einem Minimum gehalten werden, wodurch bei der Montage zusätzlich Kabellänge eingespart werden kann, von beispielsweise 40 bis 80 mm pro zu montierender elektrischer Baueinheit. Durch die Arretierung der Schirmhülse innerhalb des Gewindestutzens durch Verrasten des abstehenen Ansatzes bzw. der diametral gegenüberstehenden lappenförmigen Ansätze in den angepaßten gesenkten Ausnehmungen auf der Innenseite der Ringschulter des Gewindestutzens wird verhindert, daß sich das Kabel beim Festziehen der Klemm-Mutter mitdrehen kann, so daß das befürchtete Abbrechen von endseitig überstehenden Schirmgeflechtdrähtchen sicher verhindert wird.

Die Erfindung und vorteilhafte Einzelheiten werden nachfolgend unter Bezug auf die Zeichnung in einer beispielsweisen Ausführungsform näher erläutert. Es zeigen:
- **Fig. 1**: ein abgewandeltes vorkonfektoniertes Kabelende mit erfindungsgemäßer Schirmhülse und Prägehülse;
- **Fig. 2**: die auseinandergezogene Teilschnittdarstellung einer erfindungsgemäßen abdichtenden Kabeldurchführung mit geschirmter Kabelverschraubung;
- **Fig. 3**: die Teilschnittdarstellung einer fertiggestellten erfindungsmäßen abdichtenden und EMF-gerechten verschraubten Kabeldurchführung und
- **Fig. 4**: die Teilschnittdarstellung eines Gewindestutzens (rechts) mit Schnitt-Ansichtsdarstellung (links) gesehen in Richtung der Pfeile A-A.

Einander entsprechende Teile sind in allen Figuren mit den gleichen Bezugshinweisen gekennzeichnet.

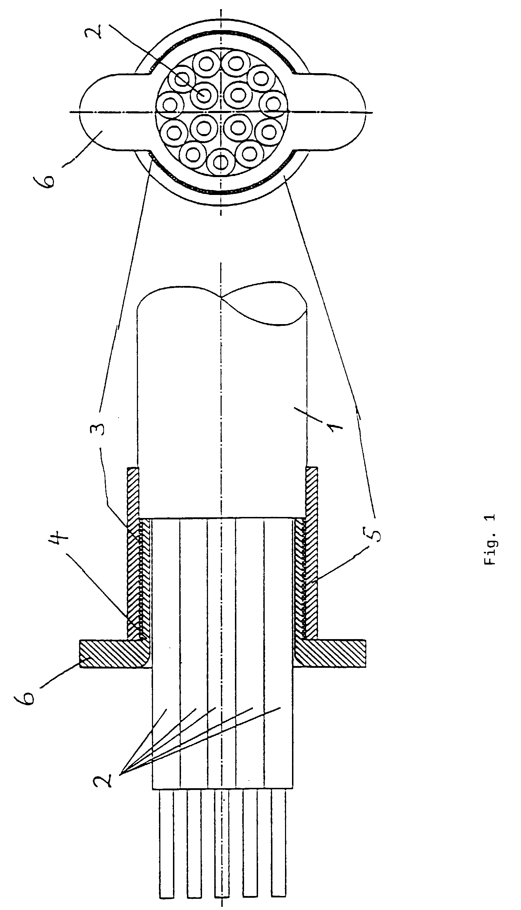

Fig. 1 läßt ein Kabel 1 erkennen, dessen Kabelmantel teilweise entfernt ist, so daß daraus hervorstehende Kabellitzen 2 freiliegen. Ein unmittelbar unter dem Kabelmantel liegendes, das Kabel vollständig umgebendes Schirmgeflecht 3 ragt ebenfalls über das stirnseitige Kabelmantelende ein Stück weit hinaus. Eine Schirmhülse 6 weist einen relativ dünnen rohförmigen Mantel auf, der die Litzen 2 umschließend unter das freigelegte Ende des Schirmgeflechts 3 geschoben ist. Wie die rechtsseitige Ansichtsdarstellung in Fig. 1 erkennen läßt, ist die Schirmhülse 6 im dargestellten Beispiel mit zwei diametral gegenüberstehenden nach außen etwa rechtwinklig zur Kabelachse abstehenden radialen Ansätzed 6 versehen, die auch als lappenförmige Ansätze bezeichnet sind. Weiterhin ist eine Prägehülse 5 im Bereich des freigelegten Schirmgeflechts 3 über die Schirmhülse 6 geschoben. Diese Prägehülse 5 besteht aus einem relativ weichen Mateial, z.B. aus Kupfer, während die Schirmhülse 6 aus einem relativ härteren Material, z.B. aus Messing. besteht.

Beim Vorkonfektionieren des abgemantelten Kabelendes wird zunächst die Prägehülse 5 über das freigelegte Kabelende im linken Bild der Fig. 1 nach rechts ausgeschoben. Sodann wird die Schirmhülse 6 wie dargestellt unter das freigelegte Schirmgeflecht 3 geschoben. Anschließend wird die Prägehülse 5 über das freigelegte Schirmgeflecht 3 bis zum Anschlag an den Ansätzen 6 geschoben und mittels einer Krimpvorrichtung, beispielsweise einer Krimpzange partiell verformt, derart, daß die Prägehülse 5 das freigelegte Schirmgeflecht 3 gegen die Schirmhülse 4 preßt, so daß sich ein guter mechanischer und elektrischer Kontakt zwischen der Prägehülse 5, dem freigelegten Schirmgeflecht 3 und der Schirmhülse 6 ergibt, wobei gleichzeitig der Kabelmantel noch fixiert werden kann.

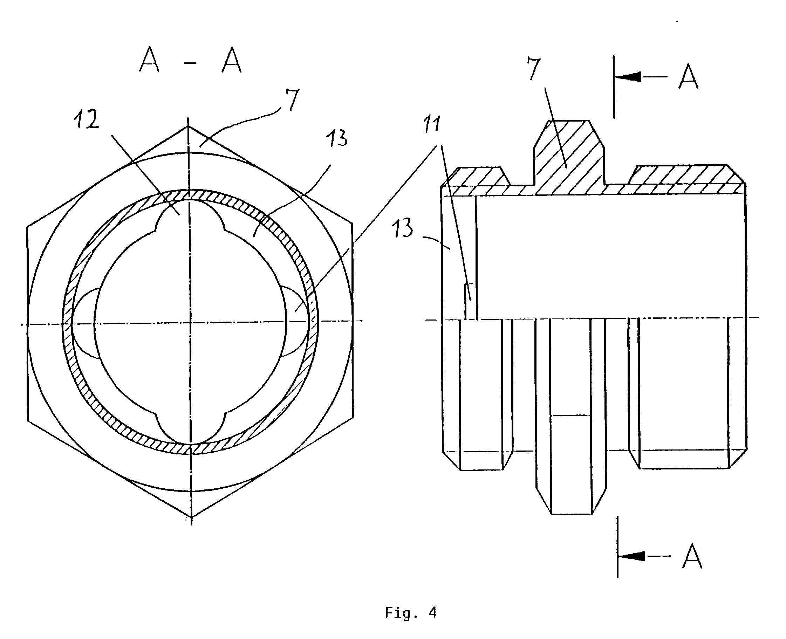

Die Fig. 4 verdeutlicht die Montage der Kabeldurchführung.
Das linksseitige Ende eines rohrförmigen Gewindestutzens 7 ist beispielsweise in die Wand des Gehäuses eines elektrischen Geräts eingezogen. Dieser Gewindestutzen 7 weist, wie die Fig. 4 zeigt. im dargestellten Beispiel am gehäuseseitigen Ende eine radial einwärts stehende Ringschulter 13 auf, deren Innendurchmesser zumindest die problemlose Durchführung des Bündels der Litzen 2 ermöglicht. Diese Ringschulter 13 ist, wie die linke Zeichnung der Fig. 4 erkennen läßt, mit zwei diametral gegenübestehenden durchgehenden Axialausnehmungen 12 versehen, deren Kontur und Radialabmessungen auf die radialen Ansätze 6 der Schirmhülse 4 angepaßt sind, so daß letztere bei entsprechender Winkelstellung des vorkonfektionierten Kabels (vergleiche Fig. 1) durch die Axialausnehmungen 12 hindurchrutschen können, so daß das vorkonfektionierte Kabel im Geräteinneren problemlos verschaltet werden kann. Sind die einzelnen Litzen 2 innerhalb des Geräts angeschlossen, so wird das vorkonfektionierte Kabel mit den über die Ringschulter 13 hinausreichenden Ansätzen 6 in den Gewindestutzen hinein zurückgezogen und um einen Winkelbetrag geringfügig verdreht, im dargestellten Beispiel um 90°, wobei jetzt die Ansätze 6 in innenseitige, gesenkte Ausnehmungen 11 an der Ringschulter 13 einrasten. Ein Verdrehen des Kabels ist jetzt nicht mehr möglich.

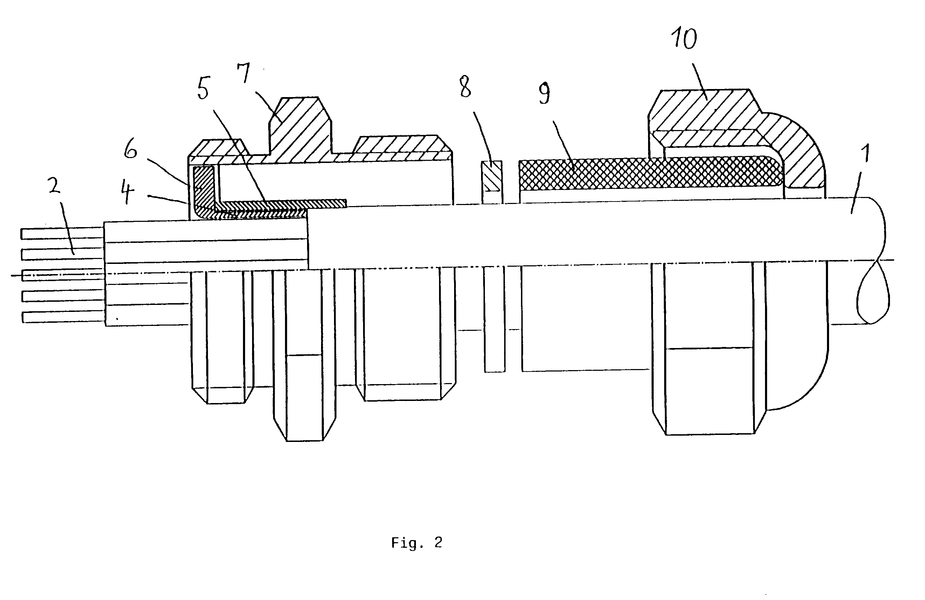

Anschließend wird (vergleiche wiederum Fig. 2), ein Druckring 8 in den Gewindestutzen 7 eingeschoben, bis er an der Ringschulter 13 anliegt. Sodann wird eine Quetschdichtung 9 (Dichtmanschette) eingeschoben und mittels einer Klemm-Mutter 10, die auf das rechtsseitige Außengewinde des Gewindestutzens geschraubt wird, festgezogen.

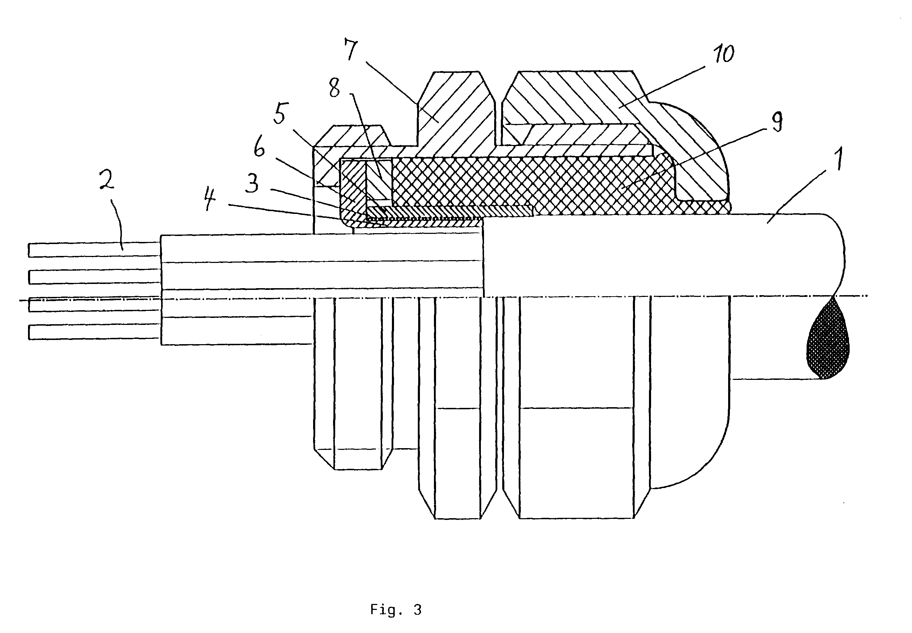

Die Fig. 3 zeigt die komplettierte HF-sichere Kabeldurchführung und Kabelverschraubung.

## Patentansprüche

1. Abdichtende Kabeldurchführung für geschirmte Kabel mit
- einem in eine Gehäusewandbohrung einzusetzenden rohrförmigen Gewindestutzen (7),
- einer auf ein gehäusewandaußenseitiges Gewinde des Gewindestutzens (7) aufzuziehenden Klemm-Mutter (10),
- einer im Inneren des Gewindestutzens (7) axial verschieblichen Druck-Ringscheibe (8), die durch eine von der Klemm-Mutter (10) anzupressende Quetschdichtung (9) gegen eine radial einwärtsstehende Ringschulter (13) am Gewindestutzen (7) gedrückt wird und
- einer zwischen die Kabelschirmung (3) und die Kabellitze(n) (2) einzuschiebenden Schirmhülse (4), die am stimseitigen Ende der Kabelschirmung (3) mindestens einen radial abstehenden Ansatz (6) aufweist,
**gekennzeichnet durch**
- eine auf der Außenseite der Kabelschirmung (3) über die Schirmhülse (4) zu schiebende Prägehülse (5) und durch
- mindestens eine auf den mindestens einen radialen Ansatz (6) der Schirmhülse (4) angepaßte durchgehende Axialausnehmung (12) in der Ringschulter (13) des Gewindestutzens (7).

2. Kabeldurchführung nach Anspruch 1, gekennzeichnet durch mindestens eine auf den mindestens einen radialen Ansatz (6) der Schirmhülse (4) angepaßte gesenkte Ausnehmung (11) auf der der Kabelschirmung (3) zugewandten Innenseite der Ringschulter (13) an einer gegenüber der durchgehenden Axialausnehmung (12) verdrehten Position zur drehgesicherten Verrastung und Kontaktverbesserung für die durch die Prägehülse (5) fixierte Schirmhülse (4).

3. Kabeldurchführung nach Anspruch 1 oder 2, **dadurch gekennzeichnet,** daß die Prägehülse (5) aus einem weicheren Material als die Schirmhülse (5) besteht.

4. Kabeldurchführung nach Anspruch 3, **dadurch gekennzeichnet,** daß die Prägehülse (5) aus Kupfer und die Schirmhülse (4) aus Messing besteht.

5. Kabeldurchführung nach einem der vorstehenden Ansprüche, **dadurch gekennzeichnet,** daß die Quetschdichtung (9) zur Verbesserung des elektrischen Übergangswiderstands aus einem Elastomer mit eingelagerten Leitdrähten besteht.

## Claims

1. Sealing cable penetration for shielded cables, having
- a tubular threaded stub (7) which is to be inserted into a housing wall bore,
- a locking nut (10) which is to be tightened onto a thread of the threaded stub (7) which is on the outside of the housing wall,
- an annular clamping disc (8) which can be axially displaced in the interior of the threaded stub (7) and is forced, by a pinch seal (9) which is to be pressed on by the locking nut (10), against a radially inwardly projecting annular shoulder (13) on the threaded stub (7), and
- a shielding sleeve (4) which is to be inserted between the cable shield (3) and the cable strand(s) (2) and has at least one radially projecting shoulder (6) at the front end of the cable shield (3),
characterized by
- a stamping sleeve (5) which is to be pushed over the shielding sleeve (4) on the outside of the cable shield (3), and by
- at least one continuous axial recess (12), adapted to the at least one radial shoulder (6) of the shielding sleeve (4), in the annular shoulder (13) of the threaded stub (7).

2. Cable penetration according to Claim 1, characterized by at least one sunken recess (11) which is adapted to the at least one radial shoulder (6) of the shielding sleeve (4), on the inside, facing the cable shield (3), of the annular shoulder (13) at a position rotated with respect to the continuous axial recess (12), and is intended to latch against rotation of, and improve the contact of the shielding sleeve (4) fixed by the stamping sleeve (5).

3. Cable penetration according to Claim 1 or 2, characterized in that the stamping sleeve (5) consists of a softer material than the shielding sleeve (5).

4. Cable penetration according to Claim 3, characterized in that stamping sleeve (5) consists of-copper, and the shielding sleeve (4) consists of brass.

5. Cable penetration according to one of the preceding claims, characterized in that for the purpose of improving the electric contact resistance, the pinch seal (9) consists of an elastomer having embedded conducting wires.

## Revendications

1. Passe-câble étanche pour des câbles blindés avec
- une tubulure filetée (7) en forme de tube, à placer dans un alésage d'une paroi de boîtier,
- un écrou de blocage (10) à serrer sur un filet de la tubulure filetée (7) du côté extérieur de la paroi du boîtier,
- une rondelle de pression (8) coulissant axialement à l'intérieur de la tubulure filetée (7), qui est pressée par un joint écrasé (9) à presser par l'écrou de blocage (10) contre un épaulement annulaire (13) radialement intérieur sur la tubulure filetée (7), et
- une douille de protection (4) à insérer entre le blindage du câble (3) et le(s) toron(s) du câble (2), qui présente au moins une butée radialement saillante (6) à l'extrémité frontale du blindage du câble (3),
caractérisé par
- une douille à empreintes (5) à glisser au-dessus de la douille de protection (4) sur la face extérieure du blindage du câble (3), et par
- au moins un évidement axial continu (12) dans l'épaulement annulaire (13) de la tubulure filetée (7), adapté à la au moins une butée radiale (6) de la douille de protection (4).

2. Passe-câble suivant la revendication 1, caractérisé par au moins un évidement creusé (11) adapté à la au moins une butée radiale (6) de la douille de protection (4), sur la face intérieure de l'épaulement annulaire (13) tournée vers le blindage du câble (3) dans une position tournée par rapport à l'évidement axial continu (12), pour le verrouillage contre la rotation et l'amélioration du contact pour la douille de protection (4) fixée par la douille à empreintes (5).

3. Passe-câble suivant la revendication 1 ou 2, caractérisé en ce que la douille à empreintes (5) est constituée d'une matière plus ductile que la douille de protection (5).

4. Passe-câble suivant la revendication 3, caractérisé en ce que la douille à empreintes (5) est constituée de cuivre et la douille de protection (4) de laiton.

5. Passe-câble suivant l'une quelconque des revendications précédentes, caractérisé en ce que le joint écrasé (9) est constitué d'un élastomère avec des fils conducteurs noyés pour améliorer la résistance électrique de transition.
